# FASCICULE DE BREVET EUROPEEN

(11) **EP 1 084 482 B1**
(45) Date de publication et mention de la délivrance du brevet: **18.02.2004**
(21) Numéro de dépôt: 99923643.3
(22) Date de dépôt: 31.05.1999
(51) Int. Cl.: G06K 19/077

(54) **PROCEDE DE FABRICATION D'UNE CARTE A CIRCUIT INTEGRE ET CARTE OBTENUE**
VERFAHREN ZUR HERSTELLUNG EINER IC-KARTE UND EINE SOLCHE HERGESTELLTE KARTE
METHOD FOR PRODUCING AN INTEGRATED CIRCUIT CARD AND CARD PRODUCED ACCORDING TO SAID METHOD

(30) Priorité: 12.06.1998 FR 9807602
(43) Date de publication de la demande: 21.03.2001
(73) Titulaire: Gemplus, 13881 Gémenos Cedex (FR)
(72) Inventeur: FIDALGO, Jean, Christophe, F-13420 Gémenos (FR); ELBAZ, Didier, F-13010 Marseille (FR); ZAFRANY, Michael, F-13006 Marseille (FR); PATRICE, Philippe, 13190 Allauch (FR)
(86) Numéro de dépôt international: PCT/FR1999/001268
(87) Numéro de publication internationale: WO 1999/066445

(56) Documents cités:
- GB-A- 2 120 861
- JP-A- 9 076 680
- US-A- 5 005 282
- US-A- 5 615 476
- US-A- 5 740 606

## Description

L'invention concerne procédé de fabrication d'une carte à circuit intégré dans lequel il est d'abord procédé à la réalisation d'un module qui comporte notamment au moins un circuit intégré et des plages de contact. Ce circuit intégré peut être relié à un circuit d'exploitation incorporé dans un appareil dans lequel la carte est être insérée.

Le circuit intégré du module peut être par exempte un circuit de mémoire ou un microprocesseur.

Le module est destiné à être inséré dans un corps de carte, généralement réalisé en matière plastique, de sorte que les plages de contact soient affleurantes au niveau de la face supérieure du corps.

Selon une technique classique, on utilise un film support en matériau plastique diélectrique généralement enduit d'une colle thermodurcissable et sur une face duquel est déposée grâce à la colle thermodurcissable une couche d'un matériau conducteur, par exemple métallique. La couche métallique est découpée de manière à faire apparaître, pour chaque module, des plages de contact et des pistes d'interconnexion.

Le circuit intégré est rapporté sur une face inférieure du film support et ses bornes sont reliées électriquement, selon diverses méthodes connues, à chacune des plages de contact. Éventuellement, la face inférieure du film support est recouverte d'une résine d'encapsulation dans laquelle le circuit intégré et ses moyens de raccordement sont noyés de manière à en assurer une parfaite protection.

Ensuite, le module est individualisé par découpe du film support selon un contour prédéfini et il est inséré dans une cavité aménagée dans le corps de carte. La fixation du module dans la cavité .est par exemple assurée par collage.

L'invention a pour but de réduire les coûts de fabrication d'une carte à circuit intégré, notamment liés aux matériaux qui entrent en jeu dans la fabrication du module et ceux liés aux diverses opérations d'assemblage.

L'invention remplace le matériau plastique diélectrique et sa colle thermodurcissable par une masse adhésive support thermoactivable qui est habituellement utilisée en aval pour fixer te module dans la cavité.

L'invention est définie dans les revendications indépendantes.

Le document US5615476, qui correspond au préambule de la revendication 1, décrit un procédé de production de supports de données tels que cartes à puces, à modules électroniques. Ces modules sont produits séparément et un circuit intégré ainsi que des bornes de contact sont électriquement connectés. Les modules électroniques individuels sont connectés avec une bande et sont solidarisés avec des corps de supports de données. Il est prévu d'estamper des bornes de contact pour chacun de modules électroniques individuels. Ce document ne prévoit pas d'interposer une seconde masse adhésive rigidifiée avant dépôt de la première masse adhésive.

Le document US5005282 décrit un procédé de production de carte d'identité ou cartes à mémoire. Ce document ne décrit pas un isolant constitué d'une masse adhésive dépourvue de support.

Le document JP9076680 décrit un module électronique comprenant un contact sous forme de couche métallique, dans laquelle une disposition de zones de contact avec des surfaces mutuellement isolées est formée par des interruptions. Le circuit et les connexions sont entourés par un composé déposé par jet de matière. Ce document ne prévoit pas une seconde masse adhésive rigidifiée avant dépôt de la première masse adhésive.

Le document US5740606 décrit un procédé de fabrication de jeu de modules électroniques pour carte à mémoire. Une pluralité de trous est formée dans un substrat en forme de feuille isolante, qui sont remplis d'un matériau conducteur pour établir une continuité électrique entre des premières et deuxièmes faces.

Le document GB2120861 décrit des conducteurs formés sur un substrat en métal sélectivement gravable de façon électrolytique, pour former des métallisations. Ces conducteurs sont formés des deux côtés d'un substrat.

Le document EP0493738 décrit un support d'information, comportant un corps de carte avec une cavité, où un module est encarté. Ce module se compose d'un substrat avec d'un premier côté plusieurs plages de contact. En vis-à-vis sur te verso, le module comporte une puce. La puce est entourée par une résine de protection et fixée au corps de carte à l'aide d'une couche thermalactivatable de colle équipée d'ouvertures.

Le document FR2761497 (FR9704093) décrit la fabrication d'une carte à puce, comprenant un microcircuit relié à des éléments d'interface formant un bornier et/ou une antenne. Les connexions entre des plots et les éléments d'interface est opérée par dépôt au moyen d'une seringue d'une substance conductrice à faible viscosité qui reste souple après son application.

L'invention se rapporte également à une carte à circuit intégré.

D'autres caractéristiques et avantages de l'invention apparaîtront dans la description détaillée.
- les figures 1, 2A, 4A, 5A, 6, et 7 sont des vues schématiques en coupe selon un plan vertical illustrant différentes étapes d'un procédé de fabrication d'une carte à circuit intégré ;
- la figure 3A est une vue de dessous correspondant à l'étape illustrée à la figure 2A ;

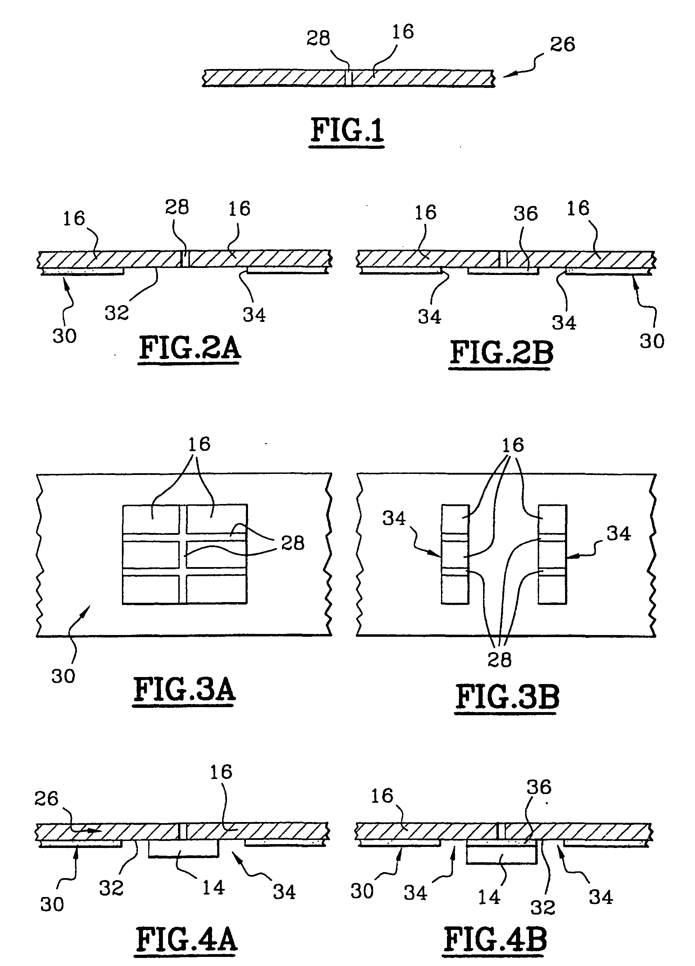

- les figures 2B, 3B et 4B illustrent des variantes de réalisation des étapes illustrées aux figures 2A, 3A et 4A ;

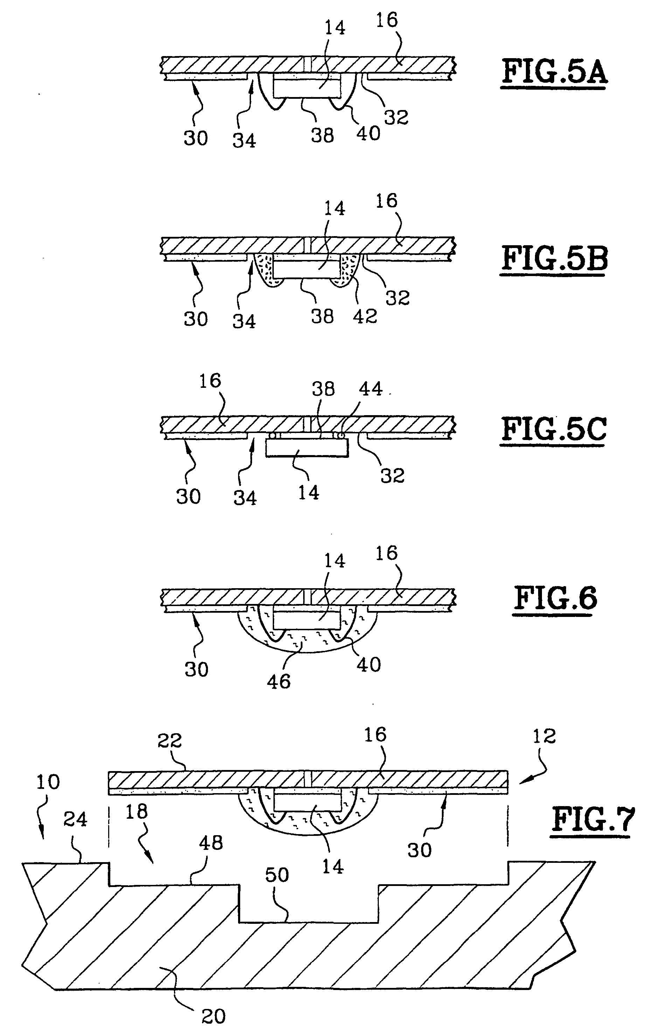

- les figures 5B et 5C sont deux variantes de réalisation de l'étape illustrée à la figure 5A ;

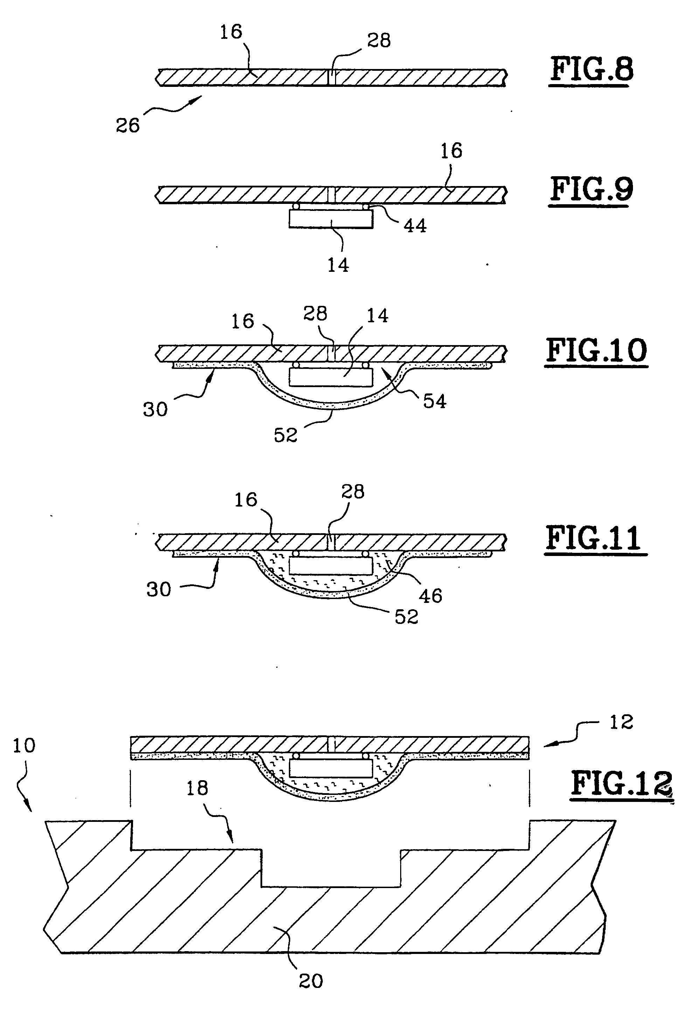

- les figures 8 à 12 sont des vues en coupe selon un plan vertical illustrant les différentes étapes successives d'un second procédé ; et

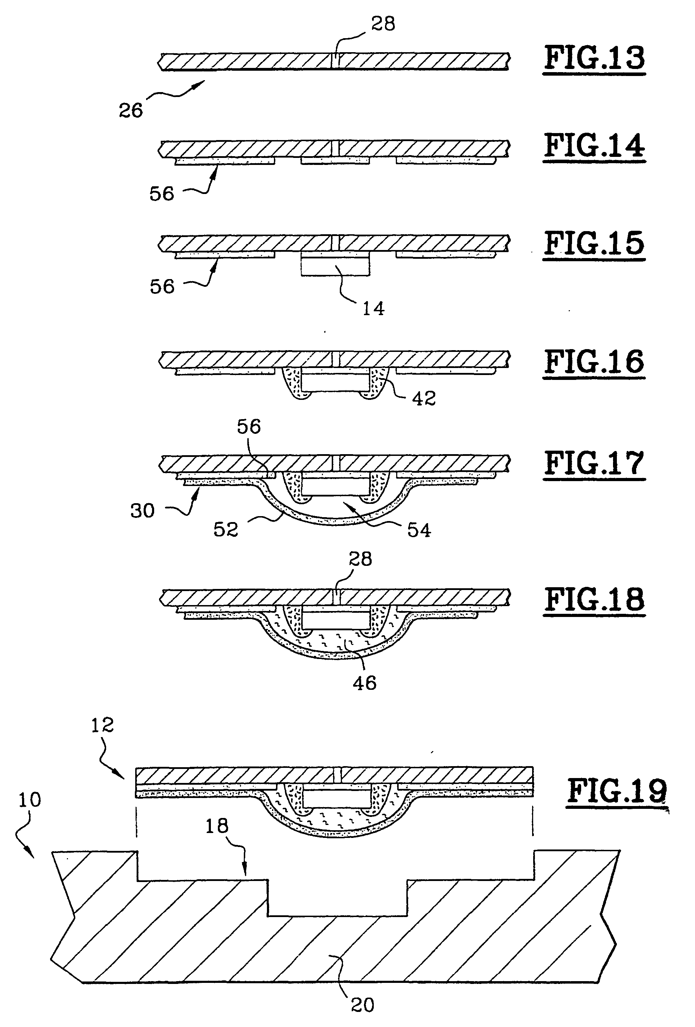

- les figures 13 à 19 sont des vues en coupe selon un plan vertical illustrant un procédé selon l'invention.

On a illustré à la figure 7 une étape d'un procédé de fabrication d'une carte à circuit intégré 10, appelée étape d'encartage, au cours de laquelle un module 12, qui comporte notamment un circuit intégré 14 et des plages de contact 16, est engagé dans une cavité 18 aménagée dans un corps de carte 20 de telle sorte qu'une face supérieure 22 des plages de contact 16, qui forme aussi une face supérieure du module 12, affleure sensiblement au même niveau qu'une face supérieure 24 du corps de carte 20.

On a illustré sur les figures 1 à 6 différentes étapes permettant la réalisation du module 12.

Comme on peut le voir sur la figure 1, les plages de contact 16 sont formées dans un élément de plaque 26 en matériau conducteur. De préférence, l'élément de plaque 26 aura la forme d'un ruban le long duquel seront formées plusieurs séries de plages de contact 16, chaque série de plages de contact 16 étant destinée à former les plages de contact d'un module 12.

L'élément de plaque 26 est par exemple réalisé à l'aide d'un matériau métallique tel que le cuivre, le bronze, un alliage cuivre-fer, ou un alliage fer-nickel. L'épaisseur de l'élément de plaque peut par exemple être de 70 microns, mais on peut éventuellement envisager d'utiliser un élément de plaque 26 de 35 microns d'épaisseur.

Pour améliorer la nature des contacts électriques, l'élément de plaque 26 peut être recouvert, par exemple par électrodéposition, de couches superposées de nickel puis d'or ou d'argent puis de palladium.

Comme on peut le voir sur la figure 1, mais plus particulièrement sur les figures 3A et 3B, les plages de contact 16 sont par exemple au nombre de six par série et elles sont séparées l'une de l'autre, au moins partiellement au cours de cette première étape, par des fentes 28. Comme on le verra par la suite, les séries de plages de contact sont destinées à être séparées d'une partie périphérique de l'élément de plaque 26 en forme de ruban de manière à, une fois séparées, être indépendantes électriquement l'une de l'autre. Cependant, avant cette séparation par découpe, les plages de contact restent solidaires, par leur partie périphérique, de la partie périphérique de l'élément de plaque, ce qui assure leur maintien en position pendant la réalisation du module.

Les fentes 28 peuvent être formées par découpe mécanique (estampage), par attaque électrochimique, ou par tout autre procédé connu.

Dans une étape ultérieure, on peut voir aux figures 2A, 3A, 2B, 3B, qu'une masse adhésive support 30 est appliquée contre la face inférieure 32 de l'élément de plaque 26.

La masse adhésive support est de préférence réalisée à l'aide d'un matériau thermoactivable, c'est-à-dire qui ne devient pleinement adhésif que lorsqu'on provoque sa réticulation, en l'occurrence par la chaleur. Pour déposer cette masse adhésive support sur la face inférieure 32 de l'élément de plaque 226 on effectue un pressage à chaud qui va partiellement activer la masse adhésive support. Après cette opération et un refroidissement jusqu'à la température ambiante, la masse adhésive support présente un faible pouvoir adhérent sur la face opposée à l'élément de plaque, ce qui permet une opération ultérieure de découpe sans adhésion à l'outil de coupe. Ce type d'adhésif est couramment appelé "hot-melt" et il se présente sous la forme d'un ruban ou une couche dont l'épaisseur peut par exemple être de l'ordre de 70 micromètres.

Cette masse adhésive support est une colle fournie en rouleaux à réaction thermoplastique non autocollante notamment par la Société BEIERSDORF sous la référence TESA 8420. Elle comporte notamment un mélange de résine phénolique et un caoutchouc nitrile.

Elle est apte à présenter un comportement ou phase thermoplastique seul et une phase thermodurcissable en fonction de la température. En outre, elle présente une bonne ductilité à froid qui permet par exemple d'absorber des pressions sur la puce sans l'endommager.

De préférence, la masse adhésive activable possède un état non réversible ou non réactivable après une activation spécifique.

Ainsi, pour le « hot-melt » lors de la fixation du module dans la cavité, on active la masse à une température qui de préférence correspond à la phase thermodurcissable. L'avantage est de rendre le « Hot-melt » non-réactivable juste après une dernière étape du procédé et par ce biais d'empêcher un décollage frauduleux du module.

On peut toutefois utiliser d'autres types de masse adhésives activables de différentes manières notamment par un catalyseur ou par des rayonnements ultraviolets dès l'instant qu'ils sont non collants à froid. On peut utiliser en particulier des adhésifs thermofusibles ou thermocollants.

La masse adhésive est homogène sur son épaisseur et se distingue des adhésifs bicouches avec ou sans feuille support intermédiaire qui pourraient néanmoins être utilisées mais avec beaucoup moins d'intérêt. L'avantage d'une masse adhésive homogène est d'avoir un ruban au coût le plus réduit possible et d'avoir plus de masse adhésive pour une même épaisseur de ruban.

La masse adhésive support 30 sera également de préférence pourvue, sur sa face inférieure, d'une pellicule de protection (non représentée), constituée d'un matériau très bon marché (papier sulfuré, polyester...) qui sera par exemple retirée au moment de l'encartage du module. La pose, par exemple par lamination, est effectuée en veillant à ce que l'adhésif ne s'échappe pas au travers des fentes 28 pour dépasser au-dessus de la face supérieure 22 de l'élément de plaque 26.

Comme on peut le voir plus particulièrement sur les figures 3A et 3B, la masse adhésive support 30 comporte, en correspondance avec chaque série de plages de contact 26, au moins une fenêtre 34 par laquelle la face inférieure des plages de contact 16 reste accessible.

Dans l'exemple de réalisation des figures 2A et 3A, la fenêtre 34 est unique pour une série de plages de contact 16 tandis que, dans l'exemple de réalisation des figures 2B et 3B, il existe deux fenêtres 34 donnant accès chacune à la face inférieure 32 de trois plages de contact 16.

Bien entendu, on pourrait prévoir que, au niveau de chaque série de plages de contact 26, la masse adhésive support 30 comporte autant de fenêtres 34 que la série comporte de plages de contact 16, chaque fenêtre 34 donnant accès à la face inférieure 32 de l'une des plages de contact 16.

Dans ces deux exemples de réalisation, les fenêtres 34 sont de forme rectangulaire. Cependant, d'autres formes pourront être adoptées en fonction notamment de la forme et de la disposition des plages de contact 16.

A l'étape illustrée aux figures 4A et 4B, le circuit intégré 14 est fixé du côté de la face inférieure 32 des plages de contact 16.

Dans l'exemple illustré à la figure 4A, le circuit intégré 14 est fixé directement contre la face inférieure 32 des plages 16, au centre de la fenêtre 34, par exemple à l'aide d'une colle (non représentée).

Dans l'exemple de réalisation de la figure 4B, le circuit intégré 14 est fixé du côté de la face inférieure 32 de l'élément de plaque 26 grâce à une portion 36 du ruban 30 qui s'étend entre les deux fenêtres 34. Ainsi, le circuit intégré 14 se trouve fixé sensiblement au centre de la série de plages de contact 16, sans nécessiter l'apport d'un moyen de fixation particulier puisque l'on utilise les propriétés adhésives du ruban 30 préalablement déposé sur la face inférieure 32 de l'élément de plaque 26. Dans ce cas, on pourra procéder, pour assurer une fixation particulièrement fiable du circuit intégré au cours des deux étapes suivantes de réalisation du module, à un chauffage local de la portion 36 de masse adhésive support 30 par laquelle le circuit intégré est collé contre l'élément de plaque 26. Ce chauffage pourra se faire par exemple au travers de l'élément de plaque 26, en chauffant localement celui-ci au droit de la partie 36 dont on veut assurer la réticulation ou bien en utilisant un outil chauffant la puce lors de son report, ou enfin en chauffant par un rayonnement localisé (type laser) la surface correspondant à l'emplacement de la puce.

Les figures 5A, 5B, 5C, 6 et 7 illustrent des étapes suivantes du procédé, dans le cas de la variante illustrée aux figures 2B, 3B, 4B pour laquelle la fixation du circuit intégré 14 est assurée par la masse adhésive support 30.

On a illustré aux figures 5A, 5B, 5C trois variantes de réalisation d'une étape au cours de laquelle est réalisée la connexion électrique entre le circuit intégré 14 et les plages de contact 16.

Dans l'exemple de réalisation de la figure 5A, le circuit 14 est agencé de telle sorte que sa face active 38, qui porte des bornes de contact (non représentées), est orientée vers le bas. Les bornes du circuit intégré 14 sont reliées chacune à une plage de contact 16 grâce à un fil de connexion 40 dont les deux extrémités sont soudées respectivement à la borne du circuit intégré 14 et à la face inférieure 32 de la plage de contact 16. De la sorte, chaque fil de connexion 40 s'étend au travers de l'une des deux fenêtres 34 de la masse adhésive support 30.

Dans l'exemple de réalisation de la figure 5B, la face active 38 du circuit intégré 14 est également tournée vers le bas mais chaque borne du circuit intégré 14 est reliée à la plage de contact 16 correspondante par un amas de résine conductrice 42 qui est déposé par exemple au moyen d'une seringue ou équivalent. La résine utilisée peut être une colle chargée avec des particules conductrices ou être une résine intrinsèquement conductrice. Cette méthode de réalisation de la liaison électrique du circuit intégré 14 aux plages de contact 16 est décrite dans la demande de brevet FR 2 761 497.

Dans le troisième exemple illustré à la figure 5C, la liaison électrique du. circuit intégré 14 avec les plages de contact 16 est réalisée grâce à un assemblage de la puce selon un procédé du type "flip-chip" dans lequel la face active 38 du circuit intégré est tournée vers le haut, en regard de la face inférieure 32 de l'élément de plaque 26. La face active 38 comporte, au niveau de chacune des bornes du circuit 14, des bossages ou "bumps" 44 qui sont destinés à venir directement au contact de la face inférieure 32 de la plage conductrice correspondante 16. Les bossages 44 sont réalisés par exemple à l'aide d'un alliage étain-plomb et la liaison électrique est réalisée par fusion de ce bossage.

Dans ce mode de réalisation, on notera que la souplesse de la masse adhésive support 30 permet que, éventuellement, la portion 36 du ruban qui est agencée entre le circuit intégré 14 et l'élément de plaque 26 soit légèrement écrasée pour permettre la liaison de chacun des bossages 44 avec la plage de contact 16 correspondante.

On a illustré à la figure 6 une étape suivante de réalisation du module 12 au cours de laquelle la face inférieure du module 12 est recouverte, au moins partiellement, d'une couche de résine d'encapsulation destinée à assurer la protection du circuit intégré 14 et des moyens de liaison 40, 42, 44 qui assurent le raccordement électrique du circuit intégré 14 avec les plages de contact 16. Dans l'exemple de la figure 6, on a repris la variante de réalisation illustrée à la figure 5A dans laquelle les moyens de liaison sont réalisés par des fils de connexion 40.

La résine d'encapsulation 46 pourra par exemple être déposée sous forme fluide avant d'être réticulée. Eventuellement, on peut aussi prévoir une opération de fraisage de la partie inférieure de la résine d'encapsulation 46 pour calibrer la hauteur totale du module 12.

A ce stade, le module 12 est entièrement achevé et il suffit donc de le séparer d'une portion périphérique de l'élément de plaque 26 par découpe, par exemple par poinçonnage ou à l'aide d'un faisceau laser. Le contour du module 12 est tel que, une fois découpé, les plages de contact 16 ne sont plus reliées par aucun pont de matière conductrice de sorte qu'elles sont électriquement indépendantes les unes des autres pour ne pas provoquer de court circuit entre les bornes du circuit intégré, sauf bien entendu pour le cas où un tel court-circuit serait nécessaire au fonctionnement du circuit intégré 14.

Comme on le voit à la figure 7, la taille du module 12 est supérieure à la taille de la couche de résine d'encapsulation 46 de telle sorte que, sur tout le pourtour du module 12, on trouve apparente la face inférieure de la masse adhésive support 30 qui est destinée à assurer la fixation du module 12 dans le corps de carte 20.

Comme on peut le voir sur cette figure 7, la cavité 18 aménagée dans le corps de carte 20 comporte une portion périphérique 48 de faible profondeur, et une portion centrale 50 de plus grande profondeur. La portion périphérique 48 présente ainsi une profondeur sensiblement égale à l'épaisseur cumulée des plages de contact 16 et de la masse adhésive support 30 de telle sorte, lors de l'opération d'encartage, la face inférieure de la masse adhésive support 30 étant amenée au contact de la paroi de fond de la portion périphérique 38 pour pouvoir y adhérer, la face supérieure 22 des plages de contact 16 se trouve alors automatiquement en affleurement au même niveau que la face supérieure 24 du corps de carte 20.

Au contraire, la partie centrale 50 de la cavité 18 présente une profondeur suffisante pour recevoir la partie du module 12 qui est recouverte de la résine de protection 46 et qui présente donc l'épaisseur la plus importante.

Une fois le module 12 reçu dans la cavité 18, il suffit de procéder au chauffage de la masse adhésive support 30 pour assurer la réticulation de l'adhésif et ainsi assurer une fixation parfaite du module 12 sur le support de carte 20.

On a illustré sur les figures 8 à 12 un deuxième procédé de fabrication d'une carte à circuit intégré. Dans ce deuxième procédé, la masse adhésive support 30 n'est posée contre la face inférieure 32 de l'élément de plaque 26 qu'après la fixation du circuit intégré 14 contre cette face inférieure 32 et après la réalisation des connexions électriques entre le circuit intégré 14 et les plages de contact 16.

Ainsi, après l'étape de formation des fentes 28 dans l'élément de plaque 26, qui est illustrée à la figure 8 et qui est similaire à celle illustrée à la figure 1, on procède directement, ainsi que cela est illustré à la figure 9, à la fixation et au raccordement électrique du circuit intégré 14. Dans cette figure 9, on a illustré le cas où le circuit intégré 14 est assemblé selon le procédé dit "flip-chip" mais, bien entendu, tout autre procédé de fixation et de connexion du circuit intégré 14 peut être utilisé, notamment ceux illustrés aux figures 5A et 5B relatives au premier procédé.

Le circuit intégré 14 sera par exemple fixé par collage à l'aide d'une colle (non représentée).

Comme on peut le voir à la figure 10, la masse adhésive support 30 qui est posée contre la face inférieure 32 de l'élément de plaque 26 est dépourvue de fenêtres. Ainsi, elle recouvre l'intégralité de la face inférieure 32 de l'élément de plaque 26, y compris au niveau du circuit intégré 14. Toutefois, pour ne pas endommager ce dernier, on prévoira de préférence que la masse adhésive support 30 soit localement déformée pour créer un renflement 52 au niveau du circuit intégré 14, ce renflement n'étant pas pressé contre la face inférieure 32 des plages de contact 16, ni contre le circuit intégré 14 ou ses moyens de liaison 40, 42, 44.

Le renflement 52 et l'élément de plaque 26 délimitent ainsi un logement sensiblement fermé 54 qui n'est ouvert vers l'extérieur que par les fentes 28 qui délimitent les plages de contact entre elles. Les liaisons 40, 42, 44 et le circuit intégré (14) se trouvent donc protégées à l'intérieur du logement 54.

Comme on peut le voir sur la figure 11, on peut alors envisager de remplir le logement 54 avec une résine d'encapsulation 46 qui, comme dans le premier procédé selon l'invention, est destiné à assurer une protection encore plus efficace de ces derniers. Le remplissage peut par exemple se faire au travers de l'une des fentes 28 qui séparent les plages de contacts 16 les unes des autres.

L'ensemble ainsi formé est alors encarté dans le corps de carte 20 pour y être fixé grâce à la masse adhésive support 30 dont l'adhérence est provoquée par exemple par chauffage au travers des plaques de contact 16.

Le procédé selon l'invention, qui est illustré aux figures 13 à 19, est une variante du deuxième procédé dans laquelle on a prévu de renforcer la résistance mécanique du module 12 en interposant, entre l'élément de plaque 26 et la masse adhésive support 30 qui est destinée à assurer la fixation du module 12 dans le corps de carte 20, une seconde couche de masse adhésive 56.

Ainsi que cela est illustré à la figure 14, la couche de résine 56 est par exemple posée sur la face inférieure 32 de l'élément de plaque 26 après la formation des fentes 28 qui séparent les plages des contacts 16 les unes des autres, mais avant la fixation et la connexion du circuit intégré 14.

Comme on peut le voir à la figure 14, la couche de résine de rigidification 56 est elle aussi pourvue de fenêtres 34, similaires à celles décrites à propos du premier procédé selon l'invention, afin de permettre l'accès à la face inférieure des plages de contact 16 pour assurer le raccordement électrique du circuit intégré 14.

Par exemple, on pourra utiliser comme couche de résine de protection 46 une seconde masse adhésive similaire à celui qui a décrit précédemment, et similaire à celle qui sera utilisée pour assurer la fixation du module 12 sur le corps de carte 20 ainsi que cela est illustré aux figures 17 à 19. Toutefois, pour que cette seconde couche assure son rôle de rigidification de l'élément de plaque 26, il est nécessaire, dès l'étape illustrée à la figure 14, d'assurer la réticulation de l'adhésif, par exemple par chauffage s'il s'agit d'un adhésif thermoactivable.

La fixation du circuit intégré 14, qui est illustrée à la figure 15, est assurée par exemple au moyen d'une colle (non représentée).

A l'étape de la figure 16, on a illustré une possibilité de réalisation du raccordement électrique du circuit intégré 14 avec les plages de contact 16, en l'occurrence par le procédé de dispense décrit en référence à la figure 5C à propos du premier procédé. Bien entendu, tout autre mode de réalisation des moyens de connexion peut être envisagé.

Une fois la fixation et la connexion du circuit intégré réalisées, les étapes illustrées aux figures 17, 18 et 19 sont identiques à celles décrites en relation avec les figures 10, 11 et 12 à propos du deuxième procédé.

Le procédé de réalisation d'une carte à circuit intégré selon l'invention présente l'avantage, par rapport à l'art antérieur, de pouvoir se dispenser du film support qui, dans l'art antérieur, n'assurait qu'une fonction de support des plages de contact 16 et ne participait activement à la fixation, ni à la rigidification du module 12.

## Revendications

1. Procédé de fabrication d'une carte à circuit intégré, comportant l'étape consistant à réaliser un module (12) qui est fixé sur un corps de carte (20) et qui comporte notamment un circuit intégré (14) et des plages de contact (16), l'étape de réalisation du module (12) comportant une étape consistant à former, dans un élément de plaque (26) en matériau conducteur, des fentes (28) qui délimitent au moins partiellement des zones de l'élément de plaque (20) destinées à former les plages de contact (16), et une étape ultérieure consistant à recouvrir, au moins partiellement, une face inférieure (32) de l'élément de plaque (26) d'une masse adhésive support (30) par laquelle le module (12) est destiné à être fixé ultérieurement sur le corps de carte (20), la masse adhésive présentant une phase thermoplastique et une phase thermodurcissable en fonction de la température
**caractérisé en ce que** une seconde couche de masse adhésive de rigidification (56) est déposée et activée sur la face inférieure de l'élément support avant le dépôt de la masse adhésive support (30).

2. Procédé selon la revendication 1,
**caractérisé en ce que** la masse adhésive support (30) recouvre le circuit intégré (14).

3. Procédé selon l'une des revendications 1 ou 2,
**caractérisé en ce qu'**il comporte une étape de fixation du circuit intégré (14) du côté de la face inférieure (12) de l'élément de plaque.

4. Procédé selon la revendication 3
**caractérisé en ce que** l'étape de fixation du circuit intégré (14) est postérieure à celle de pose de la masse adhésive de rigidification (56), et **en ce que** le circuit intégré (14) est fixé sur le module (12) par la masse adhésive de rigidification (56).

5. Procédé selon la revendication 4, **caractérisé en ce que** le circuit intégré (14) comporte des bornes qui sont reliées électriquement à une face inférieure (32) des plages de contact (16) par des moyens de liaison (40, 42, 44), et **en ce que** la masse adhésive de rigidification (56) comporte au moins une fenêtre de connexion par laquelle la face inférieure (32) des plages de contact (16) est apparente pour permettre le passage des moyens de liaison (40, 42, 44).

6. Procédé selon la revendication 5 **caractérisé en ce que** la fenêtre de connexion dans la masse adhésive de rigidification (56) est formée avant l'étape de pose de la masse adhésive support (30) sur l'élément de plaque (26).

7. Procédé selon la revendication 1, **caractérisé en ce que** l'étape de pose de la masse adhésive support (30) est postérieure à la fixation du circuit intégré (14) sur l'élément de plaque (26).

8. Procédé selon la revendication 7, **caractérisé en ce que** la masse adhésive support (30) recouvre le circuit intégré (14).

9. Procédé selon la revendication 8, **caractérisé en ce que**, dans la zone du circuit intégré (14), la masse adhésive support (30) est déposée de manière à protéger le circuit intégré (14).

10. Procédé selon la revendication 9, **caractérisé en ce que** un logement (54) est rempli d'une résine de protection (46).

11. Procédé selon l'une des revendication 7 à 9, **caractérisé en ce que** la seconde couche de masse adhésive est interposée entre la masse adhésive support (30) et la face inférieure (32) de l'élément de plaque (26).

12. Procédé selon la revendication 11, **caractérisé en ce que** la seconde couche de masse adhésive (56) est activée avant la pose de la masse adhésive (30) par laquelle le module (12) est destiné à être fixé sur le corps de carte (20).

13. Procédé selon l'une des revendications 1 à 12, **caractérisé en ce que** la masse adhésive (30) et thermoactivable.

14. Procédé selon l'une des revendications 1 à 13, **caractérisé en ce que** la massé adhésive (30) est activable par rayonnements.

15. Procédé selon l'une des revendications 1 à 12, **caractérisé en ce que** la masse adhésive activable possède un état non réversible après une activation spécifique.

16. Procédé selon l'une des revendications 1 à 15, **caractérisé en ce qu'**il comporte une étape de découpe du module (12) par laquelle ce dernier est séparé de l'élément de plaque (26).

17. Carte à circuit intégré fabriquée selon le procédé de l'une des revendications 1 à 16, comportant un module dans un élément de plaque (26) en matériau conducteur, des fentes (28) qui délimitent au moins partiellement des zones de l'élément de plaque (20) destinéest à former les plages de contact (16), et un circuit intégré relié aux plages de contact, une face inférieure (32) de l'élément de plaque (26) étant recouvert au moins partiellement d'une masse adhésive support (30) par laquelle le module (12) est destiné à être fixé ultérieurement sur un corps de carte (20), avec la masse adhésive qui recouvre le circuit intégré, charactérisée en ce que une seconde couche de masse adhésive de rigidification (56) est déposée entre la face inférieure de l'élément de plaque et la masse adhésive support.

## Claims

1. A method of manufacturing an integrated-circuit card, comprising the step consisting of producing a module (12) which is fixed to a card body (20) and which comprises in particular an integrated circuit (14) and contact areas (16), the step of producing the module (12) comprising a step consisting of forming, in a plate element (26) made from conductive material, slots (28) which at least partially delimit zones of the plate element (20) intended to form the contact areas (16), and a subsequent step consisting of at least partially covering a bottom face (32) of the plate element (26) with a supporting adhesive mass (30) by means of which the module (12) is intended to be fixed subsequently to the card body (20), the adhesive mass having a thermoplastic phase and a thermosetting phase according to the temperature, **characterised in that** a second layer of stiffening adhesive mass (56) is deposited and activated on the bottom face of the support element before the deposition of the supporting adhesive mass (30).

2. A method according to Claim 1, **characterised in that** the supporting adhesive mass (30) covers the integrated circuit (14).

3. A method according to one of Claims 1 or 2, **characterised in that** it comprises a step of fixing the integrated circuit (14) on the same side as the bottom face (12) of the plate element.

4. A method according to Claim 3, **characterised in that** the step of fixing the integrated circuit (14) is subsequent to that of placing the stiffening adhesive mass (56), and **in that** the integrated circuit (14) is fixed to the module (12) by the stiffening adhesive mass (56).

5. A method according to Claim 4, **characterised in that** the integrated circuit (14) comprises terminals which are electrically connected to a bottom face (32) of the contact areas (16) by connection means (40, 42, 44), and **in that** the stiffening adhesive mass (56) comprises at least one connection window by means of which the bottom face (32) of the contact areas (16) is visible to allow passage of the connecting means (40, 42, 44).

6. A method according to Claim 5, **characterised in that** the connection window in the stiffening adhesive mass (56) is formed before the step of placing the supporting adhesive mass (30) on the plate element (26).

7. A method according to Claim 1, **characterised in that** the step of placing the supporting adhesive mass (30) is subsequent to the fixing of the integrated circuit (14) on the plate element (26).

8. A method according to Claim 7, **characterised in that** the supporting adhesive mass (30) covers the integrated circuit (14).

9. A method according to Claim 8, **characterised in that**, in the area of the integrated circuit (14), the supporting adhesive mass (30) is deposited so as to protect the integrated circuit (14).

10. A method according to Claim 9, **characterised in that** a housing (54) is filled with a protective resin (46).

11. A method according to one of Claims 7 to 9, **characterised in that** the second layer of adhesive mass is interposed between the supporting adhesive mass (30) and the bottom face (32) of the plate element (26).

12. A method according to Claim 11, **characterised in that** the second layer of adhesive mass (56) is activated before the placing of the adhesive mass (30) by means of which the module (12) is intended to be fixed to the card body (20).

13. A method according to one of Claims 1 to 12, **characterised in that** the adhesive mass (30) is activatable by heat.

14. A method according to one of Claims 1 to 13, **characterised in that** the adhesive mass (30) is activatable by radiation.

15. A method according to one of Claims 1 to 12, **characterised in that** the activatable adhesive mass has a non-reversible state after a specific activation.

16. A method according to one of Claims 1 to 15, **characterised in that** it comprises a step of cutting the module (12) by means of which the latter is separated from the plate element (26).

17. An integrated-circuit card manufactured according to the method of one of Claims 1 to 16, comprising a module in a plate element (26) made from conductive material, slots (28) which at least partially delimit zones of the plate element (20) intended to form the contact areas (16), and an integrated circuit connected to the contact areas, a bottom face (32) of the plate element (26) being at least partially covered with a supporting adhesive mass (30) by means of which the module (12) is intended to be fixed subsequently to a card body (20), with the adhesive mass covering the integrated circuit, **characterised in that** a second layer of stiffening adhesive mass (56) is deposited between the bottom face of the plate element and the supporting adhesive mass.

## Patentansprüche

1. Herstellungsverfahren einer IC-Karte, mit einem Schritt zur Fertigung eines Moduls (12), das auf einem Kartenkörper (20) befestigt ist und insbesondere eine integrierte Schaltung (14) und Kontaktflächen (16) umfasst, wobei der Fertigungsschritt des Moduls (12) einen Schritt zur Bildung von Schlitzen (28) in einem Plattenelement (26) aus leitendem Material umfasst, die zumindest teilweise Bereiche des Plattenelements (20) abgrenzen, die Kontaktflächen bilden sollen, sowie einen späteren Schritt zum Beschichten, zumindest teilweise, einer Unterseite (32) des Plattenelements (26) mit einer Trägerklebmasse (30), mit der das Modul (12) später an dem Kartenkörper (20) befestigt werden soll, wobei die Klebmasse eine thermoplastische Phase und eine je nach Temperatur wärmehärtende Phase aufweist, **dadurch gekennzeichnet, dass** eine zweite Schicht Versteifungsklebmasse (56) vor dem Aufbringen der Trägerklebmasse (30) auf der Unterseite des Trägerelements aufgebracht und aktiviert wird.

2. Verfahren nach Anspruch 1, **dadurch gekennzeichnet, dass** die Trägerklebmasse (30) die integrierte Schaltung (14) beschichtet.

3. Verfahren nach einem der Ansprüche 1 oder 2, **dadurch gekennzeichnet, dass** es einen Befestigungsschritt der integrierten Schaltung (14) auf der Seite der Unterseite (12) des Plattenelements umfasst.

4. Verfahren nach Anspruch 3, **dadurch gekennzeichnet, dass** der Befestigungsschritt der integrierten Schaltung (14) nach demjenigen des Aufbringens der Versteifungsklebmasse (56) erfolgt, und dass die integrierte Schaltung (14) durch die Versteifungsklebmasse (56) am Modul (12) befestigt wird.

5. Verfahren nach Anspruch 4, **dadurch gekennzeichnet, dass** die integrierte Schaltung (14) Klemmen umfasst, die über Verbindungsmittel (40, 42, 44) mit einer Unterseite (32) der Kontaktflächen (16) elektrisch verbunden sind, und dass die Versteifungsklebmasse (56) mindestens ein Anschlussfenster aufweist, durch das die Unterseite (32) der Kontaktflächen (16) sichtbar ist, um die Durchführung der Verbindungsmittel (40, 42, 44) zu ermöglichen.

6. Verfahren nach Anspruch 5, **dadurch gekennzeichnet, dass** das Anschlussfenster in der Versteifungsklebmasse (56) vor dem Aufbringungsschritt der Trägerklebmasse (30) auf das Plattenelement (26) gebildet wird.

7. Verfahren nach Anspruch 1, **dadurch gekennzeichnet, dass** der Aufbringungsschritt der Trägerklebmasse (30) nach der Befestigung der integrierten Schaltung (14) auf dem Plattenelement (26) erfolgt.

8. Verfahren nach Anspruch 7, **dadurch gekennzeichnet, dass** die Trägerklebmasse (30) die integrierte Schaltung (14) beschichtet.

9. Verfahren nach Anspruch 8, **dadurch gekennzeichnet, dass** die Trägerklebmasse (30) im Bereich der integrierten Schaltung (14) so aufgebracht wird, dass sie die integrierte Schaltung (14) schützt.

10. Verfahren nach Anspruch 9, **dadurch gekennzeichnet, dass** eine Aufnahme (54) mit einem Schutzharz (46) gefüllt ist.

11. Verfahren nach einem der Ansprüche 7 bis 9, **dadurch gekennzeichnet, dass** die zweite Schicht Klebmasse zwischen der Trägerklebmasse (30) und der Unterseite (32) des Plattenelements (26) eingefügt ist.

12. Verfahren nach Anspruch 11, **dadurch gekennzeichnet, dass** die zweite Schicht Klebmasse (56) vor dem Aufbringen der Klebmasse (30), mit der das Modul (12) am Kartenkörper (20) befestigt werden soll, aktiviert wird.

13. Verfahren nach einem der Ansprüche 1 bis 12, **dadurch gekennzeichnet, dass** die Klebmasse (30) thermoaktivierbar ist.

14. Verfahren nach einem der Ansprüche 1 bis 13, **dadurch gekennzeichnet, dass** die Klebmasse (30) durch Strahlungen aktivierbar ist.

15. Verfahren nach einem der Ansprüche 1 bis 12, **dadurch gekennzeichnet, dass** sich die aktivierbare Klebmasse nach einer spezifischen Aktivierung in einem nicht reversierbaren Zustand befindet.

16. Verfahren nach einem der Ansprüche 1 bis 15, **dadurch gekennzeichnet, dass** es einen Stanzschritt des Moduls (12) umfasst, bei dem das letztere vom Plattenelement (26) getrennt wird.

17. IC-Karte, hergestellt gemäß dem Verfahren nach einem der Ansprüche 1 bis 16, mit einem Modul, das in einem Plattenelement (26) aus leitendem Material Schlitze (28) umfasst, die zumindest teilweise Bereiche des Plattenelements (20) abgrenzen, die die Kontaktflächen (16) bilden sollen, und mit einer an die Kontaktflächen angeschlossenen integrierten Schaltung, wobei eine Unterseite (32) des Plattenelements (26) zumindest teilweise mit einer Trägerklebmasse (30) beschichtet ist, über die das Modul (12) später auf einem Kartenkörper (20) mit der die integrierte Schaltung beschichtenden Klebmasse befestigt werden soll, **dadurch gekennzeichnet, dass** die zweite Schicht Versteifungsklebmasse (56) zwischen der Unterseite des Plattenelements und der Trägerklebmasse aufgebracht wird.
